# EUROPÄISCHE PATENTANMELDUNG

(11) **EP 3 376 167 A1**
(43) Veröffentlichungstag der Anmeldung: **19.09.2018**
(21) Anmeldenummer: 18020097.4
(22) Anmeldetag: 14.03.2018
(51) Int. Cl.: G01D 5/20, G01B 7/02, H03K 17/95

(54) **WEGMESSKETTE**

(30) Priorität: 15.03.2017 DE 102017002464
(71) Anmelder: Brüel & Kjaer Vibro GmbH, 64293 Darmstadt (DE)
(72) Erfinder: Viehböck, Urs-Uwe, 64297 Darmstadt (DE); Morbitzer, Wilfried, 68647 Biblis (DE); Behr, Andreas, 55129 Mainz (DE); Bolle, Matthias, 64665 Alsbach-Hähnlein (DE); Roth, Manfred, 64295 Darmstadt (DE); Rau, Katarzyna, 64665 Alsbach-Hähnlein (DE)
(74) Vertreter: Völger, Karl Wolfgang

(57) **Zusammenfassung**

Die vorliegende Erfindung betrifft eine Wegmesskette (1), umfassend
- ein Sensorgehäuse (3), das einen Gehäusekörper (301) und einen Sensorkopf (303) aufweist,
- eine in dem Sensorkopf (303) angeordnete Messspule (305),
dadurch gekennzeichnet, dass
in dem Sensorgehäuse (3) eine Leiterkarte (5) angeordnet ist, die neben der Messspule (305) eine Oszillator-Einheit (501), eine Signalverarbeitungseinheit (503) und eine erste Schnittstelle (505) aufweist,
und
die erste Schnittstelle (505) eine 4 - 20 mA Schnittstelle ist.

Ferner bezieht sich die vorliegende Erfindung auf ein Verfahren zur Messung von Wegen oder Schwingwegen, insbesondere unter Verwendung der erfindungsgemäßen Wegmesskette (1).

## Beschreibung

Die vorliegende Erfindung bezieht sich auf eine Wegmesskette und ein Verfahren zur Messung von Wegen oder Schwingwegen.

Bei der Zustandsüberwachung von Maschinen, zum Beispiel mit rotierenden Bauteilen, kommen Sensoren, beispielsweise in Form von sogenannten Wegmessketten mit Wirbelstromaufnehmern, zum Einsatz, die berührungslos Abstände zwischen zwei Maschinenteilen oder daraus abgeleitete Messgrößen an eine Auswerteinheit übermitteln. Gattungsgemäße Wirbelstromaufnehmer bestehen im Wesentlichen aus einer gegen Umwelteinflüsse geschützten Messspule, die in einer Oszillatorschaltung von einem Wechselstrom angeregt wird. Um die Messspule bildet sich daher ein alternierendes magnetisches Feld aus, welches beim Einbringen eines leitfähigen Materials in dieses Feld Wirbelströme im leitfähigen Material induziert. Die Wirbelströme sind umso stärker, je kleiner der Abstand zwischen dem leitfähigen Material und der Messspule ist. Die Wirbelströme haben dabei durch ihre Rückwirkung auf die Felder zur Folge, dass die Schwingkreiseigenschaften der Oszillatorschaltung verändert werden. Die Veränderungen werden messtechnisch ausgewertet und ergeben ein abstandsabhängiges Ausgangssignal.

Gattungsgemäße Wegmessketten und Verfahren sind daher aus dem Stand der Technik an sich bekannt. So ist beispielsweise aus DE 10 2012 017 615 A1 ein Messwertaufnehmer in Form eines Wirbelstromaufnehmers vorzugsweise für eine Messkette zur Wegmessung bekannt. Dieser Messwertaufnehmer nach dem Wirbelstrom-Messverfahren wird beispielsweise bei der Maschinenüberwachung in sehr unterschiedlichen Temperaturbereichen und zur Abstandsmessung von sehr unterschiedlichen leitfähigen Materialien eingesetzt, so dass teilweise auch gleichartige Wirbelstromsensoren unterschiedliche Kennlinienverläufe aufweisen. Deshalb ist es für die Messgenauigkeit wichtig, dass im eingebauten Zustand jeder Wirbelstromaufnehmer einen möglichst linearen Kennlinienverlauf aufweist, was eine sehr aufwendige Bauart bedingt, um nichtlineare Einflussfaktoren bauartbedingt zu kompensieren. Der gattungsgemäße Aufbau des Wirbelstromaufnehmers ist zur Minimierung eines temperaturbedingten Messfehlers mit einer Messspule aus einer Widerstandslegierung und mit einem sehr dünnen Backlack zur Erreichung einer negativen Drift des Wechselstromwiderstandes versehen. Desweiteren wird die Temperaturabhängigkeit des zur Messung notwendigen Schwingkreises dadurch verringert, dass die Schwingkreiskapazität direkt im Spulenträger untergebracht ist. Zusätzlich ist zur Verbesserung der Messgenauigkeit in der Messkette noch eine Anpassungselektronik vorgesehen, die außerhalb des Sensorgehäuses untergebracht ist und ein Kompensationsnetzwerk aufweist, durch das die Messschaltung an unterschiedliche Anschlusskabellängen angepasst wird.

DE 10 2012 007 776 A1 beschreibt eine Eindraht Messkette, die eine Aufnehmer- oder Sensoreinheit mit einer darin integrierten programmierbaren Baugruppe enthält. Dabei handelt es sich bei der Sensoreinheit um eine Baueinheit, in der die Schwingungssensoren und die programmierbare Baueinheit mit zusätzlichen Verstärkerschaltungen untergebracht sind. Diese Sensoreinheit ist nach deren Einbau zur Messwerterfassung von außen nicht mehr zugänglich, sondern kann nur noch über dessen Kabelverbindung elektrisch von außen beeinflusst werden. Da diese Sensoreinheit zur genauen Auswertung der Messsignale nach deren Einbau zusätzlich eingestellt (Verstärkung) werden muss, ist dazu in dieser eine programmierbare Baugruppe vorgesehen, durch die unterschiedliche Rückkopplungswiderstände in die dortigen Verstärkerschaltungen einschaltbar sind, ohne dass in diese Schaltungen mechanisch von außen eingegriffen werden müsste.

Auf dem Markt gibt es folglich unterschiedliche Formen von Wegmessketten (englisch: "eddy current proximity probe"). Diese bekannten Wegmessketten haben gemeinsam, dass sie zwar grundsätzlich für den Einsatz in rauen Umgebungen eingesetzt werden können, dass jedoch die Oszillatorelektronik (auch als "driver" bezeichnet) aus thermischen und mechanischen Gründen von dem eigentlichen Sensor abgesetzt ist. Viele Anwendungen bei der Zustandsüberwachung von Maschinen zeigen jedoch eine wachsende Kostensensitivität. Derzeit müssen aber die bekannten Wegmessketten mit abgesetzten Oszillator eingesetzt werden, was neben der kostenintensiveren Ausführung darüber hinaus eine Montagemöglichkeit für den abgesetzten Oszillator erfordert. Zusammenfassend kann festgehalten werden, dass die Wegmessketten nach dem Stand der Technik zwar die messtechnischen und umweltbedingten Anforderungen erfüllen, jedoch bei steigenden Anforderungen an die chemische Beständigkeit und steigende Umgebungstemperaturen sehr teuer sind.

Der vorliegenden Erfindung liegt daher die technische Aufgabe zugrunde, eine Wegmesskette bereitzustellen, welche die vorstehend genannten Anforderungen erfüllt, insbesondere eine hohe chemische und thermische Beständigkeit zeigt, gleichzeitig kostengünstig ist und universell eingesetzt werden kann.

Diese Aufgabe wird in einem ersten Aspekt der vorliegenden Erfindung durch eine Wegmesskette (1) gelöst, umfassend
- ein Sensorgehäuse (3), das einen Gehäusekörper (301) und einen Sensorkopf (303) aufweist,
- eine in dem Sensorkopf (303) angeordnete Messspule (305),
dadurch gekennzeichnet, dass
in dem Sensorgehäuse (3) eine Leiterkarte (5) angeordnet ist, die neben der Messspule (305) eine Oszillator-Einheit (501), eine Signalverarbeitungseinheit (503) und eine erste Schnittstelle (505) aufweist,
und
die erste Schnittstelle (505) eine 4 - 20 mA Schnittstelle ist.

In einem zweiten Aspekt der vorliegenden Erfindung wird diese Aufgabe durch ein Verfahren zur Messung von Wegen oder Schwingungen gelöst, insbesondere unter Verwendung der erfindungsgemäßen Wegmesskette (1), umfassend die Schritte:
a) Anregen einer Messspule (305) innerhalb eines Sensorkopfs (303) durch einen mittels einer Oszillator-Einheit (501) erzeugten Wechselstrom, dabei Bilden eines elektromagnetischen Wechselfeldes,
   wobei die Oszillator-Einheit (501) als Teil einer Leiterkarte (5) in einem Sensorgehäuse (3) angeordnet ist,
b) Aussenden des elektromagnetischen Wechselfeldes durch ein den Sensorkopf (303) des Sensorgehäuses (3) abschließendes Fenster (3033),
c) Induzieren eines Wirbelstroms in einem leitfähigen Material (M), das sich im elektromagnetischen Wechselfeld vor dem Fenster (3033) befindet oder sich darin bewegt,
d) Aufnehmen der Dämpfung des elektromagnetischen Wechselfeldes in Abhängigkeit des Abstands (A) zwischen der Messspule (305) und dem leitfähigen Material (M),
e) Berechnen eines Messwertes durch die Signalverarbeitungseinheit (503),
f) Ausgeben des in Schritt e) berechneten Messwertes über eine erste Schnittstelle (505).

Die vorliegende Erfindung hat den Vorteil, dass die erfindungsgemäße Wegmesskette (1) eine kompakte Bauform hat, bei welcher die räumliche Trennung von Sensorkopf und Oszillatorelektronik überwunden wurde, ohne dass die vorteilhaften Eigenschaften insbesondere in Bezug auf die chemische Beständigkeit und die erhöhte Einsatztemperatur aufgegeben wurden. Zwar sind mit zweiteiligen Messsystemen höhere Einsatztemperaturen möglich, der Einsatz eines einteiligen Messsystems, wie es die erfindungsgemäße Wegmesskette (1) darstellt, bei über 100 °C wurde im Stand der Technik bislang nicht beschrieben. Die erfindungsgemäße Wegmesskette (1) stellt eine kostengünstige und performante Lösung für viele Messaufgaben dar. Die über die erfindungsgemäße Schnittstelle ausgegebenen Sensorsignale können direkt verarbeitet werden ohne die Notwendigkeit einer weiteren elektronischen Verarbeitungseinheit. Auf diese Weise stellt die erfindungsgemäße Wegmesskette (1) direkt ein für den Anwender verwendbares Signal bereit, d.h. ein genormtes Industriesignal von 4 - 20 mA.

Nachfolgend wird die Erfindung im Detail beschrieben.

Der erste Aspekt der vorliegenden Erfindung betrifft eine Wegmesskette (1), die ein Sensorgehäuse (3) umfasst, das einen Gehäusekörper (301) und einen Sensorkopf (303) aufweist. In dem Sensorkopf (303) ist eine Messspule (305) angeordnet.

Die erfindungsgemäße Wegmesskette (1) zeichnet sich dadurch aus, dass in dem Sensorgehäuse (3) eine Leiterkarte (5) angeordnet ist, die neben der aus dem Stand der Technik bekannten Messspule (305) auch eine Oszillator-Einheit (501), eine Signalverarbeitungseinheit (503) und eine erste Schnittstelle (505) aufweist, wobei die erste Schnittstelle (505) eine 4 - 20 mA Schnittstelle ist.

Die vorliegende Erfindung hat überraschenderweise zu dem vorteilhaften Ergebnis geführt, dass durch die miniaturisierte Auslegung der erfindungsgemäßen Leiterkarte (5) auch die Oszillator-Einheit (501) und die Signalverarbeitungseinheit (503) in dem Sensorgehäuse (3) angeordnet werden konnten. Im Gegensatz zum Stand der Technik, bei dem insbesondere bei einem für die Anwendung erweiterten Temperaturbereich die empfindliche Oszillatorelektronik von dem Sensorkopf abgesetzt sein muss, kann mit der vorliegenden Erfindung eine kompakte Bauform erreicht werden, wobei die miniaturisierte Elektronik ausreichend von äußeren Einflüssen geschützt bleibt. Dadurch, dass kein externer Oszillator vorgesehen werden muss, ergeben sich deutliche Kostenvorteile aufgrund der nicht notwendigen Befestigungsmöglichkeiten sowie Vorteile in der geometrischen Auslegung durch den gewonnenen Freiraum. Ein weiterer wesentlicher Kostenvorteil entsteht erfindungsgemäß durch die 4 - 20 mA Schnittstelle, die eine Signalauswerteeinheit (Monitor) in der Regel überflüssig macht.

Die in der erfindungsgemäßen Wegmesskette (1) angeordneten Messspule (305) kann einerseits auf einem Spulenträger angeordnet oder andererseits freitragend sein.

Der Begriff "Leiterkarte", wie er in der vorliegenden Erfindung verwendet wird, beschreibt die Einheit aus einem Bauteileträger, auf dem die Elektronikkomponenten aufgelötet und elektrisch miteinander verbunden sind.

Unter "Oszillator-Einheit" wird gemäß der vorliegenden Erfindung die zur Erzeugung des elektromagnetischen Wechselfeldes benötigte elektronische Schaltung verstanden. An bestimmten Messpunkten dieser Schaltung werden elektrische Größen erfasst und der weiteren Signalverarbeitung zugeführt.

Die Signalverarbeitungseinheit kann erfindungsgemäß eine Linearisierung und/oder eine Temperaturkompensation aufweisen. Die Signalverarbeitungseinheit bildet aus dem Zeitsignal einen Messwert (z.B. RMS, Mittelwert, peak-peak) und stellt diesen einer ersten Schnittstelle (505) bereit.

In einer Ausführungsform der erfindungsgemäßen Wegmesskette (1) weist der Sensorkopf (303) eine Metallhülse (3031) und ein in Messrichtung angeordnetes Fenster (3033) auf. Das Fenster (3033) hat die Eigenschaft, dass es gut durchlässig für elektromagnetische Wellen ist. Diese Eigenschaft wird insbesondere durch nichtleitende Materialien erfüllt.

Vorzugsweise ist das Fenster (3033) aus Keramik, wodurch vorteilhafte Eigenschaften wie Robustheit, Temperaturstabilität und chemische Resistenz erreicht werden. Alternativ können auch Glas, Glaskeramik oder spezielle Kunststoffe (z.B. Kapton (ein Polyimid) oder ein Polyetheretherketon (PEEK)) eingesetzt werden.

In einer bevorzugten Ausführungsform ist das Fenster (3033) aus Glas oder Keramik gefertigt. Damit werden die Nachteile überwunden, welche durch die verbreitet eingesetzten Fenster aus Kunststoffen, wie beispielsweise Epoxidharzen, hervorgerufen werden, welche nur eine verringerte Temperaturstabilität und eine verringerte chemische Beständigkeit aufweisen. Durch die Metallhülse, die vorzugsweise aus Edelstahl (z.B. 1.4404) gefertigt ist, in Verbindung mit dem Fenster (3033) wird eine Temperaturbeständigkeit erreicht, welche deutlich über der Einsatztemperatur der verwendeten Leiterkarte (5) liegt.

Vorzugweise beträgt die Einsatztemperatur der Wegmesskette (1) - 55 °C bis 150 °C. Insbesondere liegt die Einsatztemperatur in einem Bereich von -40°C bis 105°C, wobei hier die spezifizierten elektrischen Parameter der Wegmesskette (1) problemlos eingehalten werden. In dem erweiterten Einsatzbereich von - 55 °C bis 150 °C ist die Wegmesskette (1) weiterhin stabil, je nach Einsatzzeit und Einsatztemperatur können die spezifizierten elektrischen Parameter jedoch von den realen Werten abweichen.

Es ist aus Gründen der kompakten Bauform bevorzugt, wenn die Leiterkarte (5) über die erste Schnittstelle (505) mit Energie versorgt wird. Diese Art der Energieversorgung wird auch als "loop powered" bezeichnet und bedeutet, dass für die Energieversorgung und das Nutzsignal / die Daten nur ein gemeinsames Adernpaar benötigt wird. Die Energieversorgung "loop powered" wird insbesondere im Bereich der 4 - 20 mA Schnittstellen eingesetzt und ermöglicht den Betrieb der erfindungsgemäßen Wegmesskette (1) an einem zweiadrigen Kabel.

In einer weiteren Ausführungsform der erfindungsgemäßen Wegmesskette (1) umfasst die Leiterkarte (5) ferner einen Mikrocontroller (509), der ebenfalls über die erste Schnittstelle (505) mit Energie versorgt wird. Der Einsatz eines Mikrocontrollers (509) ermöglicht ein großes Maß an Kontroll- und Steuerungsfunktionalität auf kleinstem Bauraum und ist wesentlicher Bestandteil der digitalen Signalverarbeitung.

Der Mikrocontroller (509) kann beispielsweise Teil der Oszillator-Einheit (501) sein. Er kann Rohdaten wandeln (A/D Wandlung) und eine Signalverarbeitung (Linearisierung, Temperaturkompensation, Plausibilitätsüberprüfung, etc.) vornehmen sowie den auszugebenden Messwert berechnen. Desweiteren kann über den Mikrocontroller (509) ein Feldbus über eine zweite Schnittstelle (507) betrieben werden.

Es ist ferner bevorzugt, wenn die Wegmesskette (1) einen Anschluss mit einem zumindest zweiadrigen Kabel (7) aufweist.

Insbesondere ist bevorzugt, wenn die Wegmesskette (1) über lediglich zwei Adern des Kabels (7) betreibbar ist. Das heißt, dass das Kabel (7) bevorzugt lediglich zweiadrig ausgeführt ist.

Es ist möglich, die Wegmesskette (1) über lediglich zwei Adern des Kabels (7) an der ersten Schnittstelle (505) zu betreiben, wobei sowohl die Übertragung der Messwerte als auch die Energieversorgung der gesamten Leiterkarte (5) über diese zwei Adern erfolgt. Dieser Betrieb ist unter dem Begriff "loop powered" bekannt.

Um die Beständigkeit der erfindungsgemäßen Wegmesskette (1) in Bezug auf das Einsatzmilieu (Robustheit gegen Chemikalien) und die Temperatur zu gewährleisten, hat es sich als vorteilhaft herausgestellt, wenn die Metallhülse (3031) mit dem Fenster (3033), insbesondere einem Keramikfenster, mittels einer Lötverbindung dicht verbunden ist, insbesondere hermetisch verschlossen. Bei der Lötverbindung kann es sich insbesondere um eine Hartlotverbindung handeln.

Zusätzlich oder alternativ ist es vorteilhaft, wenn die Metallhülse (3031) mit dem Gehäusekörper (301) dicht verbunden ist, insbesondere hermetisch verschlossen, beispielsweise durch Verschweißen.

Um den Einsatzbereich der erfindungsgemäßen Wegmesskette (1) in einem erweiterten Temperaturbereich sicherzustellen, kann das Sensorgehäuse (3) auf seiner Innenseite eine Abschirmung zum mechanischen und/oder thermischen Schutz der Leiterkarte (5) aufweisen. Die Abschirmung kann beispielweise aus einer Masse bestehen, welche zwischen dem Sensorgehäuse (3) und der Leiterkarte (5) thermisch isolierend wirkt. Auf diese Weise ist es möglich, kurzzeitige Temperaturspitzen für die erfindungsgemäße Wegmesskette (1) zu tolerieren, ohne dass die Leiterkarte (5) und ihre Einzelkomponenten Schaden nehmen. So können beispielsweise Temperaturspitzen von 300 °C für eine Sekunde toleriert werden. Die Abschirmung bietet allerdings keinen Schutz gegen dauerhafte Übertemperaturen.

In einer Weiterbildung der erfindungsgemäßen Wegmesskette (1) kann die Leiterkarte (5) eine zweite Schnittstelle (507) aufweisen. Sofern diese zweite Schnittstelle (507) vorhanden ist, wird das Kabel (7) vieradrig, um auch diese Schnittstelle betreiben zu können. Grundsätzlich kann die erfindungsgemäße Wegmesskette (1) aber mit einem zweiadrigen Kabel (7) betrieben werden, wenn auf die Nutzung der zweiten Schnittstelle (507) verzichtet wird.

Diese zweite Schnittstelle (507) kann insbesondere eine Feldbusschnittstelle sein. Unter "Feldbusschnittstelle" wird erfindungsgemäß ein Bussystem verstanden, welches die erfindungsgemäße Wegmesskette (1) zwecks Kommunikation mit einem weiteren Gerät verbindet. Die zweite Schnittstelle (507) kann eine analoge und/oder eine digitale Schnittstelle sein. Mittels der Feldbusschnittstelle ist es beispielsweise möglich, ein dem Abstand (A) proportionales Signal direkt auszugeben und/oder Daten zwecks Konfiguration oder zur Messwertübertragung auszutauschen. In der Industrie ist für die digitale Kommunikation das HART Protokoll Stand der Technik.

Die vorstehenden Ausführungen und Bevorzugungen im Hinblick auf die erfindungsgemäße Wegmesskette (1) gelten für das nachstehend beschriebene erfindungsgemäße Verfahren entsprechend. Ebenso gelten die nachstehenden Ausführungen und Bevorzugungen im Hinblick auf das erfindungsgemäße Verfahren für die erfindungsgemäße Wegmesskette (1) entsprechend.

In einen zweiten Aspekt betrifft die vorliegende Erfindung ein Verfahren zur Messung von Wegen oder Schwingwegen, wobei insbesondere die vorstehend beschriebene erfindungsgemäße Wegmesskette (1) verwendet wird. Das Verfahren umfasst zunächst einen Schritt a), in dem eine Messspule (305) innerhalb eines Sensorkopfs (303) durch einen mittels einer Oszillator-Einheit (501) erzeugten Wirbelstrom angeregt wird, wobei sich ein elektromagnetisches Wechselfeld bildet. Dabei ist erfindungsgemäß die Oszillator-Einheit (501) als Teil einer Leiterkarte (5) in einem Sensorgehäuse (3) angeordnet.

In einem Schritt b) wird das elektromagnetische Wechselfeld durch ein den Sensorkopf (303) des Sensorgehäuses (3) abschließendes Fenster (3033) ausgesendet, wobei danach in einem Schritt c) ein Wirbelstrom in einem leitfähigen Material (M) induziert wird, das in das elektromagnetische Wechselfeld vor dem Fenster (3033) eingebracht wird.

Die Schritte a), b) und c) des erfindungsgemäßen Verfahrens laufen insbesondere gleichzeitig ab.

In einem Schritt d) wird die Dämpfung des elektromagnetischen Wechselfeldes in Abhängigkeit des Abstandes (A) zwischen der Messspule (305) und dem leitfähigen Material (M) aufgenommen und anschließend in einem Schritt e) ein Messwert durch die Signalverarbeitungseinheit (503) berechnet. Schließlich wird in einem Schritt f) der in Schritt e) berechnete Messwert über eine erste Schnittstelle (505) ausgegeben. Diese erste Schnittstelle ist insbesondere eine 4 - 20 mA Schnittstelle.

Das Verfahren weist grundsätzlich die gleichen Vorteile wie die vorstehend beschriebene erfindungsgemäße Wegmesskette (1) auf. Es ist mit dem erfindungsgemäßen Verfahren insbesondere möglich, mittels einer kompakten Wegmesskette (1) nicht nur Wege oder Schwingwege zu messen, sondern die aufgenommenen Werte zu verarbeiten und über die erste Schnittstelle (505) direkt als für den Anwender verwendbare Signale auszugeben.

In einer Weiterbildung des erfindungsgemäßen Verfahrens kann die Leiterkarte (5) ferner einen Mikrocontroller (509) umfassen, mit dem eine Reihe von Vorgängen durchgeführt werden können. Der Mikrocontroller (509) kann die Anregung der Messspule (305) in Schritt a) steuern und/oder die Rohdaten aus Schritt d) wandeln. Ferner kann er die Signalverarbeitung und/oder das Berechnen des Messwertes in Schritt e) vornehmen. Der Mikrocontroller (509) kann ferner die Ausgabe an der ersten Schnittstelle (505) oder, sofern vorhanden, die Ausgabe an der zweiten Schnittstelle (507) steuern.

Der Mikrocontroller (509) kann Integritätstests (Selbsttest) und Plausibilitätstests durchführen. Insbesondere kann der Mikrocontroller (509) im Rahmen der Signalverarbeitung eine Linearisierung und eine Temperaturkompensation durchführen.

Weitere Ziele, Merkmale, Vorteile und Anwendungsmöglichkeiten ergeben sich aus der nachfolgenden Beschreibung von die Erfindung nicht einschränkenden Ausführungsbeispielen anhand der Figuren. Dabei bilden alle beschriebenen und/oder bildlich dargestellten Merkmale für sich oder in beliebiger Kombination den Gegenstand der Erfindung, auch unabhängig von ihrer Zusammenfassung in den Ansprüchen oder deren Rückbeziehung. Es zeigen:
- Fig. 1: eine schematische Schnittdarstellung einer erfindungsgemäßen Wegmesskette 1 nach einer Ausführungsform der Erfindung,
- Fig. 2: eine schematische Darstellung einer Abstandmessung gemäß einer Ausführungsform der Erfindung und
- Fig. 3: Geometrien der erfindungsgemäßen Wegmesskette 1 nach zwei speziellen Ausführungsformen der Erfindung.

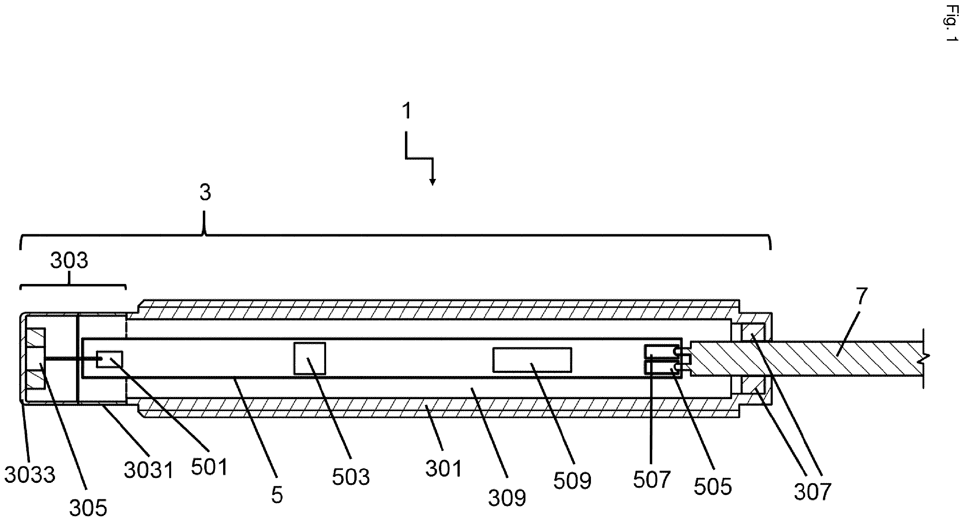

In Figur 1 ist die erfindungsgemäße Wegmesskette 1 in einer bevorzugten Ausführungsform der vorliegenden Erfindung dargestellt. Die Wegmesskette 1 besteht zunächst aus dem Sensorgehäuse 3, das sich in einen Gehäusekörper 301 und einen Sensorkopf 303 aufteilt, wobei der Sensorkopf 303 vorzugsweise hermetisch dicht mit dem Gehäusekörper 301 verbunden ist, beispielsweise durch eine Schweißverbindung.

An seinem hinteren Ende weist der Sensorkörper 3 eine Durchführung für ein Kabel 7 auf, welches über die erste Schnittstelle 505 (und/oder ggf. die zweite Schnittstelle 507) mit der Leiterkarte 5 verbunden ist. Das Kabel 7 wird dabei dicht durch das hintere Ende des Sensorgehäuses 3 geführt, wobei zur weiteren Abdichtung Dichtelemente 307, beispielsweise als ein temperaturbeständiger Dichtring und/oder Verguss (z.B. aus Fluorsilikon-Kautschuk (FVMQ)), vorgesehen sind, welche insbesondere eine Quetschverbindung mit dem Kabel 7 zur Herstellung der Dichtigkeit bilden. Um die extrem hohen Anforderungen an die Dichtigkeit nach der Schutzklasse IP69K zu erfüllen, kann noch eine Schutzkappe (nicht dargestellt) die Dichtelemente 307 vor einem direkten Wasserstrahl abschirmen.

Der Sensorkopf 303 ist aus der Metallhülse 3031 (z.B. Edelstahl 1.4404) und einem daran angebrachten Fenster 3033, in der dargestellten Ausführungsform ein Keramikfenster 3033 (beispielsweise eine Aluminiumoxid-Keramik oder eine Glaskeramik (Schott AG: Ceran, Zerodur oder Corning Inc.: Macor)) gebildet. Die Verbindung zwischen Metallhülse 3031 und Keramikfenster 3033 erfolgt insbesondere durch Löten mit Hartlot. Das Keramikfenster 3033 weist eine hervorragende chemische und thermische Stabilität auf. Diese wird beispielsweise nach DIN EN ISO 9227 gemessen mit 7,5 % Salzwasser in einem Salznebelsprühtest sowie unter Einwirkung von Lösungsmitteln (Hexan, Heptan, Isopropanol, Aceton, Methanol), sowie Seifenlösung und 32 % Ammoniaklösung. Diese chemische Beständigkeit wird durch eine thermische Stabilität von mehr als 180 °C ergänzt.

Hinter dem Keramikfenster 3033 ist die Messspule 305 angeordnet, die direkt mit der Oszillator-Einheit 501 auf der Leiterkarte 5 verbunden ist. Diese Anordnung der Oszillator-Einheit 501 direkt innerhalb des Sensorgehäuses 3 stellt eine erfindungsgemäße Besonderheit der vorliegenden Erfindung dar.

Auf der Leiterkarte 5 sind ferner in dem in Figur 1 gezeigten Ausführungsbeispiel eine Signalverarbeitungseinheit 503, eine erste Schnittstelle 505 und eine zweite Schnittstelle 507 angeordnet. Zur besseren Übersichtlichkeit der Darstellung wurde eine schematische Ansicht gewählt, in der die elektronischen Verbindungen der einzelnen Bauteile nicht dargestellt sind.

Die zweite Schnittstelle 507 kann in einer speziellen Ausführungsform als sogenannter "buffered output" ausgeführt sein. Dieser "buffered output" wird über zwei zusätzliche Adern des Kabel 7 aus der Wegmesskette 1 geführt. Er dient überwiegend als Hilfsmittel während der Installation der Wegmesskette 1 oder im Servicefall. Unabhängig von dem Messwert, der durch die Signalverarbeitungseinheit 503 berechnet wird, gibt der "buffered output" immer die Abstandsinformation aus.

In der vorliegenden Ausführungsform der Figur 1 ist der Zwischenraum zwischen der Leiterkarte 5 und dem Sensorgehäuse 3 mit einer Vergussmasse 309 ausgefüllt, die einerseits eine elektrische Isolierung bildet und andererseits einen thermischen Schutz für die Leiterkarte 5 bildet. Die Vergussmasse garantiert zudem Mindestisolationsabstände zwischen den einzelnen Bauteilen.

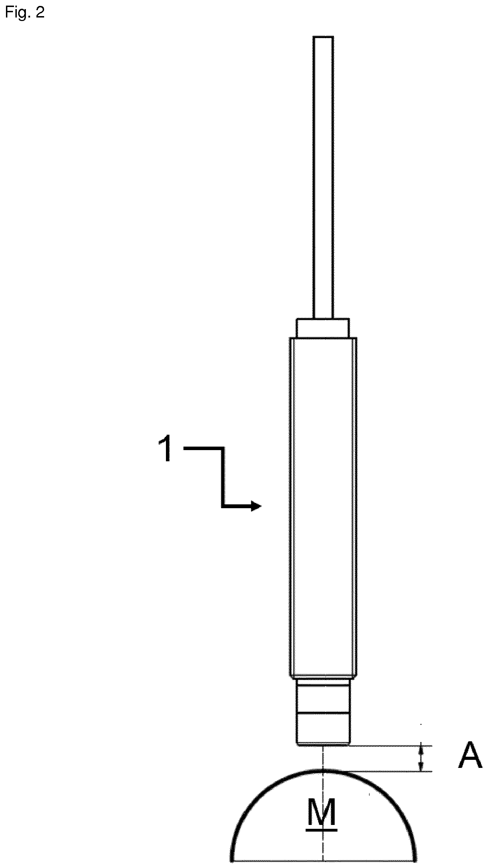

In Figur 2 wird schematisch eine Abstandsmessung gezeigt. Der Einfachheit halber ist die Wegmesskette 1 als geschlossenes Bauteil dargestellt. Durch das in Messrichtung angeordnete Keramikfenster 3033 wird das elektromagnetische Wechselfeld ausgesendet, das durch die Anregung der Messspule 305 innerhalb des Sensorkopfs 303 gebildet wird. Wird nun ein leitfähiges Material M, das in der schematischen Darstellung nur angedeutet ist, in das elektromagnetische Wechselfeld vor dem Keramikfenster 3033 eingebracht, so wird in Abhängigkeit des Abstands A dieses elektromagnetische Wechselfeld gedämpft. Aus dieser Dämpfung wird durch die Signalverarbeitungseinheit 503 der Messwert berechnet, der anschließend über die 4 - 20 mA Schnittstelle ausgegeben wird.

In der industriellen Automatisierungstechnik stellt das erfindungsgemäß verwendete Stromsignal 4 - 20 mA das am häufigsten verwendete Signal in der analogen Messwertübertragung dar. Die große Verbreitung dieses Signales ist auf die Einfachheit der Handhabung und vor allem auf die Störsicherheit zurückzuführen. Ein Stromsignal besitzt eine höhere EMV-Störfestigkeit als ein Spannungssignal, da elektromagnetische Störungen als Spannungssignale in die Signalleitung eingespeist werden und nur sehr geringe Stromänderungen an der Bürde des Empfängers verursachen.

Das erfindungsgemäß verwendete Stromsignal 4 - 20 mA findet eine sehr breite Anwendung in der Übertragung von Sensorwerten. Ferner wird das das Stromsignal 4 - 20 mA als Zweileitersignal aufgrund der Ersparnis bei der Verkabelung und der einfacheren Fehlersignalisierung häufig gegenüber der Dreileiterversion bevorzugt. Ein Leitungsbruch kann hier durch Unterschreiten des Stromwertes von 3,6 mA und ein Kurzschluss durch Überschreiten des Stromwertes von 21 mA erkannt werden (gemäß NAMUR NE43).

In einer speziellen Ausführungsform stellt die erfindungsgemäße Wegmesskette 1 einen Sensor mit 4 - 20 mA Schnittstelle nach "NAMUR NE043" (Normen-Arbeitsgemeinschaft für Mess- und Regeltechnik in der Chemischen Industrie) dar. Die NE043 beschreibt die Signalpegel für die Ausfallinformation von digitalen Messumformern mit analogem Ausgangssignal und ist im industriellen Umfeld weit verbreitet:
i) Strom ≤ 3,6 mA ⇒ Ausfallinformation
ii) 4 mA ≤ Strom ≤ 20 mA ⇒ Wert innerhalb des Messbereiches
iii) 3,8 mA < Strom < 20,5 mA ⇒ Wert innerhalb des erweiterten Messbereiches
iv) Strom ≥ 21 mA ⇒ Ausfallinformation

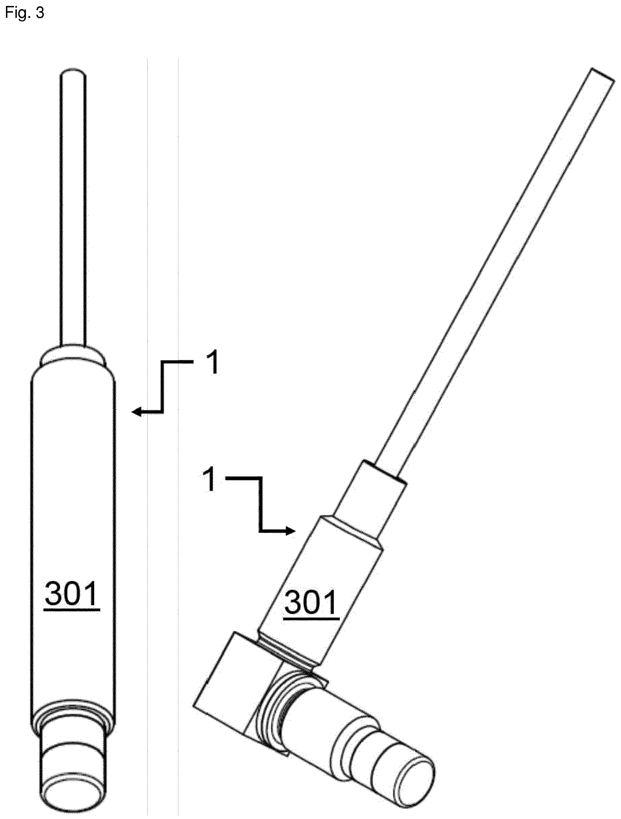

Figur 3 zeigt zwei geometrische Ausführungsformen der erfindungsgemäßen Wegmesskette 1, wobei in der linken Darstellung der Gehäusekörper 301 eine Gewindehülse aufweisen kann, die beispielsweise das Maß M10 oder 3/8" UNF hat. Eine abgewandelte Ausführungsform ist rechts daneben dargestellt, in welcher der Gehäusekörper 301 abgewinkelt ausgeführt ist, so dass das Keramikfenster 3033 in dem Sensorkopf 303 in einem Winkel, beispielsweise in einem rechten Winkel, zum Gehäusekörper 301 stehen kann. Auch in dieser Ausführungsform kann der Gehäusekörper 301 als Gewindehülse ausgeführt sein.

Mit der vorliegenden Erfindung ist es gelungen, die elektronische Schaltung der erfindungsgemäßen Wegmesskette 1 so auszulegen und zu miniaturisieren und integrierte Bauelemente für die benötigten Temperatureigenschaften zu nutzen, dass eine kompakte Bauform mit Eigenschaften erreicht wurde, die bislang die räumliche Trennung von Sensorkopf und Oszillatorelektronik erforderlich machte. Auf diese Weise kann ein erweiterter Temperaturbereich für den Einsatz der erfindungsgemäßen Wegmesskette 1 genutzt werden, da die Leiterkarte 5 mit ihren elektronischen Bauteilen ausreichend vor äußeren Einflüssen, insbesondere bezüglich Einsatzmilieu und Temperatur geschützt bleibt.

Obwohl die vorliegende Erfindung in Bezug auf eine Wegmesskette und die Messung von Wegen oder Schwingwegen beschrieben wurde, kann die erfindungsgemäße Grundidee auch für andere Sensoren angewandt werden, ohne von der vorliegenden Erfindung abzuweichen.

### Bezugszeichen

- 1: Wegmesskette
- 3: Sensorgehäuse
- 301: Gehäusekörper
- 303: Sensorkopf
- 3031: Metallhülse
- 3033: Fenster
- 305: Messspule
- 307: Dichtelemente
- 309: Vergussmasse
- 5: Leiterkarte
- 501: Oszillator-Einheit
- 503: Signalverarbeitungseinheit
- 505: erste Schnittstelle
- 507: zweite Schnittstelle
- 509: Microcontroller
- 7: Kabel
- A: Abstand zwischen der Messspule 305 und dem leitfähigen Material M,
- M: leitfähiges Material

## Patentansprüche

1. Wegmesskette (1), umfassend
- ein Sensorgehäuse (3), das einen Gehäusekörper (301) und einen Sensorkopf (303) aufweist,
- eine in dem Sensorkopf (303) angeordnete Messspule (305),
**dadurch gekennzeichnet, dass**
in dem Sensorgehäuse (3) eine Leiterkarte (5) angeordnet ist, die neben der Messspule (305)) eine Oszillator-Einheit (501), eine Signalverarbeitungseinheit (503) und eine erste Schnittstelle (505) aufweist,
und
die erste Schnittstelle (505) eine 4 - 20 mA Schnittstelle ist.

2. Wegmesskette (1) nach Anspruch 1, wobei der Sensorkopf (303) eine Metallhülse (3031) und ein in Messrichtung angeordnetes Fenster (3033) aufweist.

3. Wegmesskette (1) nach Anspruch 1 oder 2, wobei die Einsatztemperatur der Wegmesskette (1) - 55 °C bis 150 °C beträgt.

4. Wegmesskette (1) nach einem der Ansprüche 1 bis 3, wobei die Leiterkarte (5) über die erste Schnittstelle (505) mit Energie versorgt wird.

5. Wegmesskette (1) nach einem der Ansprüche 1 bis 4, wobei die Leiterkarte (5) ferner einen Microcontroller (509) umfasst, der ebenfalls über die erste Schnittstelle (505) mit Energie versorgt wird.

6. Wegmesskette (1) nach einem der Ansprüche 1 bis 5, wobei die Wegmesskette (1) einen Anschluss mit einem zumindest zweiadrigen Kabel (7) aufweist.

7. Wegmesskette (1) nach einem der Ansprüche 1 bis 5, wobei die Wegmesskette (1) über lediglich zwei Adern des Kabels (7) betreibbar ist.

8. Wegmesskette (1) nach einem der Ansprüche 1 bis 7, wobei die Metallhülse (3031) mit dem Fenster (3033) mittels einer Lötverbindung dicht verbunden ist und/oder
die Metallhülse (3031) mit dem Gehäusekörper (301) dicht verbunden ist.

9. Wegmesskette (1) nach einem der Ansprüche 1 bis 8, wobei das Sensorgehäuse (3) auf seiner Innenseite eine Abschirmung zum mechanischen und/oder thermischen Schutz der Leiterkarte (5) aufweist.

10. Wegmesskette (1) nach einem der Ansprüche 1 bis 6, 8 und 9, wobei die Leiterkarte (5) eine zweite Schnittstelle (507) aufweist.

11. Verfahren zur Messung von Wegen oder Schwingwegen, insbesondere unter Verwendung der Wegmesskette (1) nach einem der Ansprüche 1 bis 10, umfassend die Schritte:
a) Anregen einer Messspule (305) innerhalb eines Sensorkopfs (303) durch einen mittels einer Oszillator-Einheit (501) erzeugten Wechselstrom, dabei Bilden eines elektromagnetischen Wechselfeldes,
wobei die Oszillator-Einheit (501) als Teil einer Leiterkarte (5) in einem Sensorgehäuse (3) angeordnet ist,
b) Aussenden des elektromagnetischen Wechselfeldes durch ein den Sensorkopf (303) des Sensorgehäuses (3) abschließendes Fenster (3033),
c) Induzieren eines Wirbelstroms in einem leitfähigen Material (M), das sich im elektromagnetischen Wechselfeld vor dem Fenster (3033) befindet oder sich darin bewegt,
d) Aufnehmen der Dämpfung des elektromagnetischen Wechselfeldes in Abhängigkeit des Abstands (A) zwischen der Messspule (305) und dem leitfähigen Material (M),
e) Berechnen eines Messwertes durch die Signalverarbeitungseinheit (503),
f) Ausgeben des in Schritt e) berechneten Messwertes über eine erste Schnittstelle (505).

12. Verfahren nach Anspruch 11, wobei die Leiterkarte (5) ferner einen Microcontroller (509) umfasst, der
- die Anregung der Messspule (305) aus Schritt a) steuert und/oder
- Rohdaten aus Schritt d) wandelt und/oder
- Signalverarbeitung vornimmt und/oder
- das Berechnen des Messwertes in Schritt e) vornimmt und/oder
- die Ausgabe der ersten Schnittstelle (505) steuert.

13. Verfahren nach Anspruch 11 oder 12, insbesondere unter Verwendung der Wegmesskette (1) nach einem der Ansprüche 1 bis 6 und 8 bis 10, wobei der Microcontroller (509) die Ausgabe der zweiten Schnittstelle (507) steuert.
